# EUROPÄISCHE PATENTSCHRIFT

(11) **EP 1 412 948 B1**
(45) Veröffentlichungstag und Bekanntmachung des Hinweises auf die Patenterteilung: **14.11.2007**
(21) Anmeldenummer: 02758071.1
(22) Anmeldetag: 04.07.2002
(51) Int. Cl.: G11C 11/16

(54) **MAGNETISCHE SPEICHEREINHEIT UND MAGNETISCHES SPEICHERARRAY**
MAGNETIC MEMORY UNIT AND MAGNETIC MEMORY ARRAY
UNITE MEMOIRE MAGNETIQUE ET MATRICE MEMOIRE MAGNETIQUE

(30) Priorität: 10.07.2001 DE 10133373
(43) Veröffentlichungstag der Anmeldung: 28.04.2004
(73) Patentinhaber: Qimonda AG, 81739 München (DE)
(72) Erfinder: HÖNLEIN, Wolfgang, 82008 Unterhaching (DE); KREUPL, Franz, 80802 München (DE)
(74) Vertreter: Viering, Jentschura & Partner
(86) Internationale Anmeldenummer: PCT/DE2002/002458
(87) Internationale Veröffentlichungsnummer: WO 2003/007304

(56) Entgegenhaltungen:
- EP-A- 1 052 520

## Beschreibung

Die Erfindung betrifft eine magnetische Speichereinheit und ein magnetisches Speicherarray.

Die Entwicklung in der Kommunikations- und Informationstechnologie führte in den letzten Jahren zu ständig wachsenden Anforderungen an die Kapazität und die Schnelligkeit von Speicherbausteinen. Sogenannte nichtflüchtige Massenspeicher wie z.B. Festplatten, Magnetbänder oder optische Speicher zeichnen sich durch eine hohe Speicherkapazität und durch einen geringen Preis pro Megabyte Speicherkapazität aus.

Allerdings wird die herkömmliche Silizium-Mikroelektronik bei weiter voranschreitender Verkleinerung an ihre Grenzen stoßen. Insbesondere die Entwicklung zunehmend kleinerer und dichter angeordneter nichtflüchtiger Speicherelemente, die häufig auf Transistoren basieren, wird in den nächsten zehn Jahren prinzipiellen physikalischen Problemen ausgesetzt sein. Wenn Strukturabmessungen von 80nm unterschritten werden, werden die Bauelemente durch Quanteneffekte störend beeinflusst und unterhalb von Dimensionen von etwa 30nm dominiert. Auch führt die zunehmende Integrationsdichte der Bauelemente auf einem Chip zu einem dramatischen Anstieg der Abwärme.

Als eine mögliche Nachfolgetechnik der herkömmlichen Halbleiterelektronik sind Kohlenstoff-Nanoröhren bekannt. Eine Übersicht über diese Technologie gibt beispielsweise [1]. Eine Nanoröhre ist eine einwandige oder mehrwandige, röhrenartige Kohlenstoffverbindung. Bei mehrwandigen Nanoröhren ist mindestens eine innere Nanoröhre von einer äußeren Nanoröhre koaxial umgeben. Einwandige Nanoröhren weisen typisch Durchmesser von ungefähr einem Nanometer auf, die Länge einer Nanoröhre kann mehrere hundert Nanometer betragen. Die Enden einer Nanoröhre sind häufig mit jeweils einem halben Fulleren-Molekülteil abgeschlossen.

Das ausgedehnte π-Elektronensystem und die geometrische Struktur von Nanoröhren bewirken eine gute elektrische Leitfähigkeit, weshalb Nanoröhren geeignet sind für den Aufbau von Schaltkreisen mit Dimensionen im Nanometerbereich. Aus [2] ist bekannt, dass die elektrische Leitfähigkeit von Kohlenstoff-Nanoröhren die von Metallen gleicher Abmessung deutlich übersteigen kann. Aufgrund der guten elektrischen Leitfähigkeit von Nanoröhren eignen sich diese für eine große Anzahl von Anwendungen, beispielsweise für die elektrische Verbindungstechnik in integrierten Schaltkreisen, für Bauelemente in der Mikroelektronik sowie für ElektronenEmitter.

Kohlenstoff-Nanoröhren haben jedoch auch interessante Eigenschaften im Hinblick auf magnetoelektronische Anwendungen, welche die Spineigenschaften von elektrischen Ladungsträgern ausnutzen. Aus [3] ist bekannt, dass Kohlenstoff-Nanoröhren den Spin von Leitungselektronen über beträchtliche Dimensionen hinweg ohne Spinumklappprozess transportieren, wenn Leitungselektronen in eine Kohlenstoff-Nanoröhre injiziert werden. Werden Leitungselektronen mit polarisierten Spins beispielsweise ausgehend von einem ferromagnetischen Leiter in eine Kohlenstoff-Nanoröhre injiziert, so wird die Spinorientierung des Leitungselektrons in der Kohlenstoff-Nanoröhre über eine Weglänge von ungefähr 250nm aufrechterhalten. Diese charakteristische Weglänge wird als Spinkohärenzlänge bezeichnet. Auch erfolgt in Kohlenstoff-Nanoröhren vergleichsweise wenig Streuung von Leitungselektronen an Phononen und Gitterfehlern, die elastische Streulänge ist ungefähr 60nm.

Ein interessantes Konzept zur Herstellung von miniaturisierten nichtflüchtigen Speichern sind die sogenannten MRAMs (Magnetic Random Access Memory). Die Funktionsweise von MRAMs basiert auf dem Riesenmagnetowiderstands-Effekt (XMR-Effekt), dessen Grundlagen in [4] beschrieben sind. XMR-Effekte sind an Strukturen beobachtbar, bei denen zwei ferromagnetische Schichten durch eine dünne nicht-ferromagnetische Zwischenschicht getrennt sind. Sind die Magnetisierungsrichtungen der beiden ferromagnetischen Schichten zueinander antiparallel, so werden Majoritäts-Spinträger bei einem spinerhaltenden Durchgang von der ersten ferromagnetischen Schicht über die Zwischenschicht hinweg bis hin in die zweite ferromagnetische Schicht hinein zu Minoritäts-Spinträgern. Als Majoritätsladungsträger werden Leitungselektronen mit einer Spin-Orientierung bezeichnet, die der ferromagnetischen Vorzugsrichtung entspricht. Mit anderen Worten ist die Spinvorzugsrichtung in der zweiten ferromagnetischen Schicht, welche die Majoritäts-Spinträger der zweiten ferromagnetischen Schicht einnehmen, antiparallel zur Spinvorzugsrichtung in der ersten ferromagnetischen Schicht, welche die Majoritäts-Spinträger der ersten ferromagnetischen Schicht einnehmen. Daraus resultiert ein deutlich erhöhter elektrischer Widerstand bei zueinander antiparalleler Orientierung der beiden ferromagnetischen Schichten verglichen mit dem Fall einer parallelen Magnetisierung der beiden ferromagnetischen Schichten. Der Grund für die Abhängigkeit des elektrischen Widerstands von der Ausrichtung der Magnetisierungsvektoren der beiden Schichten zueinander ist der spinabhängige Tunneleffekt. Der elektrische Stromfluss zwischen beiden Schichten ist durch die Verfügbarkeit freier Zustände in den Leitungsbändern der zweiten Schicht bestimmt. Bei zueinander parallelen Magnetisierungsrichtungen finden die Elektronenspins, die in der ersten ferromagnetischen Schicht beispielsweise bevorzugt in einem "Spin up"-Zustand befindlich sind, eine hohe Anzahl freier Zustände in dem entsprechenden Band für "Spin up"-Elektronen in der zweiten ferromagnetischen Schicht, so dass ein erheblicher Tunnelstrom fließt. Bei antiparalleler Ausrichtung zueinander sind die Energiebänder derart gegeneinander verschoben, dass an der Fermi-Kante nicht ausreichend viele freie Zustände vorliegen, in welche die Elektronen mit "Spin up" tunneln könnten. Der Tunnelstrom ist in diesem Fall gering und die Schichtanordnung ist hochohmig. Eine beispielsweise mittels eines äußeren Magnetfelds erzwungene parallele Ausrichtung der Magnetisierungen führt daher zu dem XMR-Effekt, d.h. zu einer starken Verringerung des elektrischen Widerstands.

Es ist zu betonen, dass der Zwischenbereich zwischen den beiden ferromagnetischen Schichten auch eine nichtmagnetische Schicht sein kann, beispielsweise eine elektrisch isolierende Tunnelbarriere. In diesem Falle spricht man von "Tunneling Magneto Resistance" (TMR-Effekt). Bei MRAMs wird der TMR-Effekt ausgenutzt, mit anderen Worten wird der quantenmechanische Tunneleffekt mit dem Riesenmagnetowiderstands-Effekt verknüpft. MRAMs zeichnen sich durch die Nichtflüchtigkeit der gespeicherten Informationen aus und erschließen damit neue Marktsegmente, gerade auch bei tragbaren Produkten (digitale Fotokameras, intelligente Chipkarten).

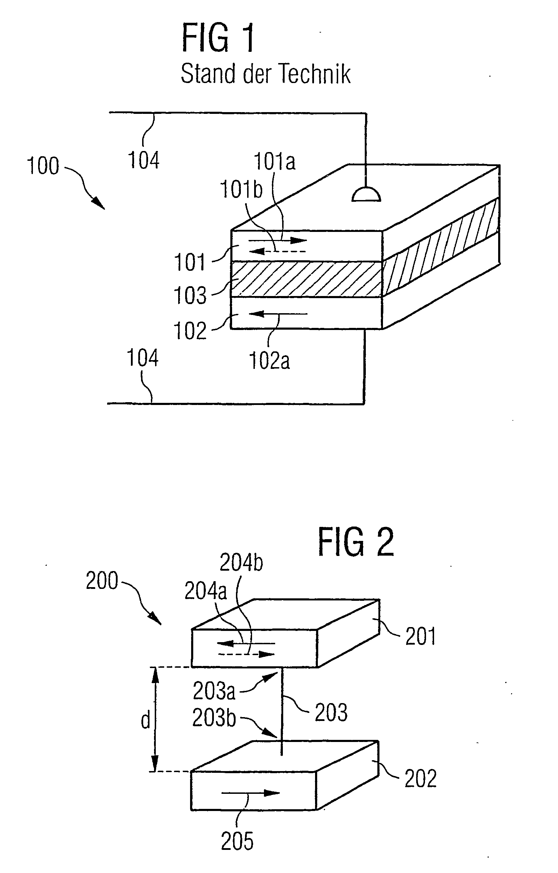

Im Weiteren wird bezugnehmend auf **Fig. 1** die Funktionsweise eines MRAM-Speicherelements beschrieben. Die in **Fig. 1** gezeigte MRAM-Speichereinheit 100 weist eine weichmagnetische Elektrode 101, eine hartmagnetische Elektrode 102 und eine dazwischen angeordnete Tunnelschicht 103 auf.

Unter einem hartmagnetischen (bzw. einem magnetisch harten) Material wird im Weiteren ein Material verstanden, bei welchem die Hysteresekurve, d.h. die Relation zwischen der Magnetisierung und der magnetischen Feldstärke eine größere Fläche einschließt als bei einem weichmagnetischen (bzw. einem magnetisch weichen) Material, dessen Hysteresekurve eine kleinere Fläche einschließt. Im Allgemeinen sind bei einem hartmagnetischen Material sowohl die Remanenz als auch die Koerzitivkraft größer als bei weichmagnetischen Materialien. Mit anderen Worten ist zum Ummagnetisieren eines weichmagnetischen Materials eine geringe Arbeit zu leisten, zum Ummagnetisieren eines hartmagnetischen Materials ist dagegen eine hohe Arbeit zu leisten. Da zum Ummagnetisieren der hartmagnetischen Elektrode 102 eine große Arbeit bzw. ein starkes externes Magnetfeld erforderlich ist, bleibt bei der hartmagnetischen Elektrode 102 eine einmal vorgegebene Magnetisierungsrichtung (in **Fig. 1** als Pfeil 102a gezeigt) in Abwesenheit extrem starker Magnetfelder dauerhaft aufrecht erhalten. Da die weichmagnetische Elektrode 101 bereits infolge einer geringen Arbeit bzw. infolge eines geringen externen Feldes ummagnetisierbar ist, kann die momentan vorliegende Magnetisierungsrichtung, die in **Fig. 1** als durchgezogener Pfeil 101a eingezeichnet ist, bereits mittels eines kleinen externen Magnetfelds in die entgegengesetzte Magnetisierungsrichtung, die in **Fig. 1** als gestrichelter Pfeil 101b eingezeichnet ist, umgekehrt werden.

In dem in **Fig. 1** gezeigten Szenario sind die Magnetisierungsrichtungen der weichmagnetischen Elektrode 101 und der hartmagnetischen Elektrode 102 zueinander antiparallel orientiert. Wird gemäß diesem Szenario mittels der elektrisch leitfähigen Zuleitung 104 zwischen die weichmagnetische Elektrode 101 und die hartmagnetische Elektrode 102 eine elektrische Spannung angelegt, so ist aufgrund des Riesenmagnetowiderstands-Effekts der Stromfluss zwischen der weichmagnetischen Elektrode 101 und der hartmagnetischen Elektrode 102 gering. Mittels Anlegen eines derarten magnetischen Feldes, das klein genug ist, um die Magnetisierungsrichtung der hartmagnetischen Elektrode 102 unbeeinflusst zu lassen, das hingegen groß genug ist, um die Magnetisierungsrichtung der weichmagnetischen Elektrode 101 umzukehren, können die Magnetisierungsrichtungen der weichmagnetischen Elektrode 101 und der hartmagnetischen Elektrode 102 in Übereinstimmung gebracht werden. Infolge des Riesenmagnetowiderstands-Effekts würde bei einer an die elektrisch leitfähigen Zuleitungen 104 angelegten Spannung zwischen der weichmagnetischen Elektrode 101 und der hartmagnetischen Elektrode 102 ein großer elektrischer Strom fließen. Das Fließen eines großen elektrischen Stroms zwischen den Elektroden 101, 102 ist beispielsweise als logischer Wert "1" interpretierbar, das Fließen eines kleinen elektrischen Stroms zwischen den Elektroden 101, 102 ist als logischer Wert "0" interpretierbar. Somit ist in der MRAM-Speichereinheit 100 eine Datenmenge von 1 Bit speicherbar.

Allerdings weist die in **Fig. 1** gezeigte MRAM-Speichereinheit 100 eine Reihe von Nachteilen auf. So ist die Tunnelschicht 103 häufig als etwa 1,5nm dicke Aluminiumoxidschicht (Al₂O₃) ausgebildet. Die homogene Oxidation einer aufgesputterten Aluminiumschicht ist technologisch schwierig. Das Herstellen der Tunnelschicht 103 ist daher schwierig und kostenaufwändig. Ferner muss die Dicke der Tunnelschicht 103 ausreichend klein gewählt sein, so dass ein ausreichend hoher Anteil der Leitungselektronen die Tunnelschicht 103 ohne Streuprozess durchqueren kann. Mit anderen Worten muss die Dicke der Tunnelschicht 103 kleiner als die mittlere Streulänge der Elektronen sein, um die Spinorientierung beim Durchgang durch die Tunnelschicht 103 aufrechtzuerhalten. Bei herkömmlichen MRAMs liegt die Dicke der Tunnelschicht 103 üblicherweise zwischen 0,5nm und 3nm. Jedoch muss zum Schreiben eines Bits in die MRAM-Speichereinheit 100 die weichmagnetische Elektrode 101 ummagnetisiert werden, ohne dass die hartmagnetische Elektrode 102 dadurch ebenfalls ummagnetisiert wird. Da die Dicke der Tunnelschicht 103 und damit der Abstand zwischen der weichmagnetischen Elektrode 101 und der hartmagnetischen Elektrode 102 nach oben durch die Notwendigkeit eines ausreichend großen Tunnelstroms begrenzt ist, ist es gemäß der aus dem Stand der Technik bekannten MRAM-Speichereinheit 100 möglich, dass beim Einschreiben eines Bits in die weichmagnetische Elektrode 101 die hartmagnetische Elektrode 102 durch das hierzu anzulegende externe magnetische Feld negativ beeinflusst, d.h. beispielsweise (teilweise) ummagnetisiert wird. Ferner erzeugt die Magnetisierung der weichmagnetischen Elektrode 101 bzw. die Magnetisierung der hartmagnetischen Elektrode 102 jeweils ein magnetisches Feld, das mit zunehmendem Abstand von den Elektroden 101, 102 abnimmt. Indem die beiden Elektroden 101, 102 zwecks Sicherstellung eines ausreichend hohen Tunnelstroms unter Beibehaltung der Spinorientierung relativ nah benachbart sind, ist eine magnetische Wechselwirkung zwischen den von der weichmagnetischen Elektrode 101 und der hartmagnetischen Elektrode 102 erzeugten magnetischen Feldern möglich. Eine solche Wechselwirkung ist geeignet, die Magnetisierungsrichtungen der Elektroden 101, 102 zu beeinflussen. Dies ist nachteilhaft, da dadurch die Gefahr besteht, dass die in die MRAM-Speichereinheit 100 einprogrammierte Datenmenge von einem Bit verloren geht. Der beschriebene Effekt führt zu einer nachteiligen Verkürzung der Haltezeit der MRAM-Speichereinheit 100.

Auch muss die Tunnelschicht 103 zum Erreichen einer hohen Integrationsdichte von MRAM-Speichereinheiten 100 in einem Speicherarray möglichst kleinflächig sein. Die in **Fig. 1** gezeigte Tunnelschicht (eine etwa 1,5nm dicke AluminiumoxidSchicht) weist pro Querschnittsfläche einen elektrischen Widerstand von ungefähr 1 MΩ nm⁻² bis ungefähr 40 GΩ nm⁻² auf. Unterschreitet die eindimensionale Ausdehnung der MRAM-Speichereinheit 100 eine Größenordnung von ungefähr 100nm, so ergibt sich ein sehr hoher Tunnelwiderstand. Ein hoher Tunnelwiderstand vergrößert jedoch die RC-Zeit der MRAM-Speichereinheit 100. Die RC-Zeit der Speichereinheit 100 ist ein Maß für die Lesezeit der MRAM-Speichereinheit 100, d.h. ein Maß für die Zeit, die zum Auslesen der in einer MRAM-Speichereinheit 100 gespeicherten Datenmenge erforderlich ist. Der hohe elektrische Widerstand der Tunnelschicht 103 führt also entweder zu einer langsamen Zugriffszeit auf die MRAM-Speichereinheit 100 oder zu einer geringen Integrationsdichte von Speichereinheiten 100 auf einem Speicherarray. Diese technologische Beschränkung ist nachteilhaft.

Aus [6] ist ein Lesekopf zum Auslesen von in einem magnetischen Speichermedium gespeicherter Information bekannt, der zwei durch eine Kohlenstoffnanoröhre getrennte ferromagnetische Schichten aufweist. Diese Schichten sind derart eingerichtet, dass sie in Anwesenheit eines ausreichend starken externen Magnetfelds zueinander parallele Magnetisierungsrichtungen aufweisen, wobei bei Ausschalten des externen Magnetfelds die Magnetisierungsrichtungen in eine zueinander antiparallele Orientierung zurückklappen.

In [7] ist ein MRAM mit einer Tunnelbarriere zwischen zwei ferromagnetischen Schichten offenbart, wobei die Magnetisierungsrichtung einer der ferromagnetischen Schichten mittels eines externen magnetischen Feldes einstellbar ist.

In [8] sind Materialien beschrieben, die sich als Tunnelbarriere einer nichtflüchtigen magnetischen Speicherzelle eignen.

Der Erfindung liegt das Problem zugrunde, eine nichtflüchtige magnetische Speichereinheit zu schaffen, bei der eine verkürzte Zugriffszeit mit einer hohen Haltezeit und einer hohen Integrationsdichte kombiniert ist.

Das Problem wird durch eine magnetische Speichereinheit und ein magnetisches Speicherarray mit den Merkmalen gemäß Anspruch 1 gelöst.

Die erfindungsgemäße magnetische Speichereinheit weist eine erste magnetisierbare Elektrode, eine zweite magnetisierbare Elektrode und zumindest eine Nanoröhre auf, welche zwischen den Elektroden in Längsrichtung angeordnet ist und welche mit ihrem ersten Längsende mit der ersten Elektrode und mit ihrem zweiten Längsende mit der zweiten Elektrode gekoppelt ist.

Die mindestens eine Nanoröhre ist vorzugsweise eine Kohlenstoff-Nanoröhre. Vorzugsweise sind bei der magnetischen Speichereinheit der Erfindung die beiden Elektroden in einem Abstand von 1nm bis 300nm zueinander angeordnet.

Die magnetische Speichereinheit der Erfindung weist eine Reihe von Vorteilen auf. Ein großer Vorteil gegenüber den bekannten MRAM-Speichereinheiten besteht darin, dass die Nanoröhre, welche die Kopplung zwischen der ersten magnetisierbaren Elektrode und der zweiten magnetisierbaren Elektrode herstellt, eine erhöhte Länge von 1nm bis 1000nm aufweist. MRAM-Speichereinheiten gemäß dem Stand der Technik weisen Tunnelschichten mit Dicken von typischerweise 1,5nm auf. Indem die Länge der Nanoröhren der erfindungsgemäßen magnetischen Speichereinheit bis zu 1000nm groß sein kann, sind die erste magnetisierbare Elektrode und die zweite magnetisierbare Elektrode voneinander räumlich weiter entfernt als gemäß dem Stand der Technik üblich. Gemäß der oben beschriebenen Funktionalität von magnetischen Speichereinheiten weisen die erste magnetisierbare Elektrode und die zweite magnetisierbare Elektrode jeweils eine nach Betrag und Richtung definierte Magnetisierung auf, wobei wünschenswert ist, dass sich die Magnetisierungen gegenseitig möglichst wenig beeinflussen. Von magnetisierten Schichten erzeugte Magnetfelder fallen mit zunehmenden Abstand von der magnetischen Schicht ab. Daher nehmen die magnetischen Feldstärken der ersten bzw. der zweiten magnetisierbaren Elektrode der magnetischen Speichereinheit der Erfindung mit zunehmenden Abstand von den Elektroden ab.

Indem die erste magnetisierbare Elektrode von der zweiten magnetisierbaren Elektrode infolge der großen Länge der Nanoröhren von bis zu 1000nm ausreichend weit entfernt ist, ist die Wechselwirkung zwischen den von der ersten magnetisierbaren Elektrode bzw. von der zweiten magnetisierbaren Elektrode erzeugten Magnetfeldern erfindungsgemäß gegenüber dem Stand der Technik vermindert.

Wie oben beschrieben, ist gemäß dem Stand der Technik die Dicke der Tunnelschicht zwischen den magnetisierbaren Elektroden aufgrund von physikalischen Anforderungen, die an die oxidische Tunnelschicht zu stellen sind, insbesondere aufgrund des hohen und zu deren Dicke direkt proportionalen elektrischen Widerstands einer oxidischen Tunnelschicht, nach oben hin begrenzt. Eine solche Begrenzung ist prinzipiell vermieden, indem anstelle der Tunnelschicht als Kopplungseinheit zwischen den magnetisierbaren Elektroden Nanoröhren verwendet sind. Der Grund hierfür ist, dass die mittlere freie Weglänge zwischen zwei Streuprozessen beim Durchlaufen von Leitungselektronen durch die Kohlenstoff-Nanoröhre wesentlich größer ist als im Falle einer oxidischen Tunnelschicht. Um die Spin-Information der Leitungselektronen zwischen den magnetisierbaren Elektroden infolge von Streuprozessen nicht zu verlieren, ist die Dicke der Kopplungseinheit zwischen den magnetisierbaren Elektroden klein gegenüber der mittleren freien Weglänge zu wählen. Der ausreichend hohe räumliche Abstand zwischen den magnetisierbaren Elektroden infolge der Wahl von Kohlenstoff-Nanoröhren als Kopplungseinheit zwischen den magnetisierbaren Elektroden unterbindet eine nachteilige gegenseitige Beeinflussung der magnetisierbaren Elektroden. Die Magnetisierungsrichtungen der magnetisierbaren Elektroden, in welchen die in der magnetischen Speichereinheit gespeicherte Datenmenge von 1 Bit kodiert ist, ist damit ausreichend sicher über einen großen Zeitraum hinweg aufrechterhalten und wird nicht durch eine nachteilige Wechselwirkung zwischen den magnetisierbaren Elektroden beschränkt. Die erfindungsgemäße magnetische Speichereinheit hat daher eine große Haltezeit. Als Haltezeit wird diejenige Zeit bezeichnet, über welche die in der magnetischen Speichereinheit zu speichernde Information aufrechterhalten bleibt.

Ferner ist zu bedenken, dass die in der magnetischen Speichereinheit speicherbare Information mittels Anlegen eines externen magnetischen Feldes an eine der magnetisierbaren Elektroden in die magnetische Speichereinheit einspeicherbar ist. Dabei ist sicherzustellen, dass das externe magnetische Feld lediglich eine, nämlich die gewünschte magnetisierbare Elektrode, derart beeinflusst, dass deren Magnetisierungsrichtung dadurch einstellbar ist. Hingegen soll die andere der magnetisierbaren Elektroden einer Speichereinheit von dem zum Einspeichern der Datenmenge von 1 Bit an die magnetische Speichereinheit anzulegenden externen Magnetfeld unbeeinflusst bleiben. Ein derartiges externes magnetisches Feld nimmt mit zunehmenden Abstand von dem Mittel zum Erzeugen dieses externen magnetischen Feldes (beispielsweise eines stromdurchflossenen Leiters) ab, so dass eine unerwünschte Beeinflussung der anderen magnetisierbaren Elektrode, welche durch das externe magnetische Feld nicht ummagnetisiert werden soll, erfindungsgemäß vermieden ist. Dadurch kann die Magnetisierungsinformation in eine der magnetisierbaren Elektroden mittels eines geeignet gewählten externen Feldes ausreichend sicher in eine der magnetisierbaren Elektroden eingespeichert werden, ohne dass eine nachteilige Beeinflussung der anderen magnetisierbaren Elektrode zu befürchten ist.

Ein weiterer Vorteil der erfindungsgemäßen magnetischen Speichereinheit ist in dem geringen Durchmesser der Nanoröhren, der typischerweise zwischen 1nm und 30nm liegt, zu sehen. MRAM-Speichereinheiten gemäß dem Stand der Technik weisen wie oben beschreiben eine technologische Grenze hinsichtlich der Integrationsdichte von MRAM-Speichereinheiten in einem MRAM-Speicherarray auf, da die Tunnelbarrieren bei Querschnittsflächen von weniger als 100nm x 100nm sehr hohe Tunnelwiderstände aufweisen, was sich nachteilig auf die RC-Zeit und damit auf die charakteristische Auslesezeit einer MRAM-Speichereinheit auswirkt. Diese technologische Grenze bezüglich der Integrationsdichte magnetischer Speichereinheiten in einem magnetischen Speicherarray ist erfindungsgemäß wesentlich verbessert. Nanoröhren mit typischen Durchmesser zwischen 1nm und 3nm weisen infolge der hohen elektrischen Leitfähigkeit von Nanoröhren einen ausreichend geringen elektrischen Widerstand auf, um die RC-Zeit und damit die Auslesezeit einer magnetischen Speichereinheit ausreichend klein zu halten. Dadurch ist mittels der Verwendung von Nanoröhren als Kopplungselement zwischen der ersten magnetisierbaren Elektrode und der zweiten magnetisierbaren Elektrode die technologische Grenze für die Integrationsdichte der magnetischen Speichereinheiten in einem magnetischen Speicherarray gegenüber dem Stand der Technik um einige Größenordnungen verbessert. Die durch die Nanoröhre vorgegebene prinzipielle technologische Grenze ist in der Querschnittsfläche der Nanoröhre gegeben, die zwischen 1nm x 1nm und 30nm x 30nm beträgt. Dadurch sind erfindungsgemäß die Rahmenbedingungen dafür verbessert, magnetische Speicherelemente mit einer hohen Integrationsdichte bereitzustellen.

Vorzugsweise ist die mindestens eine Nanoröhre der magnetischen Speichereinheit derart eingerichtet, dass sie einen quantenmechanischen Tunnelkontakt darstellt, wobei der Spinzustand von zwischen den beiden Elektroden fließenden Ladungsträgern zumindest teilweise erhalten bleibt.

Indem Kohlenstoff-Nanoröhren wie oben beschrieben eine hohe Spinkohärenzlänge von ungefähr 250nm (siehe [3]) aufweisen, bleibt eine Spin-Information, die den durch die Nanoröhre hindurch fließenden Leitungselektronen beispielsweise in einer ferromagnetischen magnetisierbaren Elektrode aufgeprägt worden ist, über Dimensionen in der Größenordnung der Spinkohärenzlänge beim Durchgang durch eine Nanoröhre erhalten. Mit anderen Worten durchlaufen Leitungselektronen eine Kohlenstoff-Nanoröhre über Dimensionen von ungefähr 250nm, ohne dass Spinumklappprozesse (Spinflips) stattfinden. Darüber hinaus ist die mittlere freie Weglänge zwischen zwei Streuprozessen für Leitungselektronen in Kohlenstoff-Nanoröhren groß. Aufgrund dieser großen mittleren freien Weglänge zwischen zwei aufeinanderfolgenden Streuprozessen und aufgrund der hohen Spinkohärenzlänge für polarisierte Leitungselektronen beim Durchlaufen von Kohlenstoff-Nanoröhren sind Kohlenstoff-Nanoröhren besonders gut als Kopplungselemente zwischen einer ersten magnetisierbaren Elektrode und einer zweiten magnetisierbaren Elektrode, zwischen denen XMR-Effekte auftreten sollen, geeignet. Wird beim Betreiben der oben beschriebenen magnetischen Speichereinheit ein Leitungselektron mit einer Spinausrichtung, welche mittels einer magnetisierten Elektrode diesem Leitungselektron vorgegeben ist, in eine Kohlenstoff-Nanoröhre eingekoppelt, so transportiert dieses Leitungselektron über Dimensionen von 250nm hinweg diese Spin-Information hin zu einer zweiten magnetisierbaren Elektrode, ohne dass Spinumklappprozesse stattfinden. Mit anderen Worten geht die Spin-Information beim Durchlaufen einer Kohlenstoff-Nanoröhre nicht verloren. Bezogen auf die oben beschriebene magnetische Speichereinheit ist es mittels Verwenden einer Kohlenstoff-Nanoröhre also auch ermöglicht, die zwischen zwei magnetisierbaren Elektroden gespeicherte Information von 1 Bit fehlerfrei auszulesen. Sind die Magnetisierungsrichtungen der beiden Elektroden unterschiedlich, so ist der elektrische Widerstand zwischen diesen beiden magnetisierbaren Elektroden groß (XMR-Effekt) und der Stromfluss zwischen den magnetisierbaren Elektroden bei einer fest angelegten elektrischen Spannung gering. Sind die Magnetisierungsrichtungen der beiden magnetisierbaren Elektroden gleich, so ist der elektrische Widerstand zwischen den magnetisierbaren Elektroden geringer und der Stromfluss zwischen den beiden magnetisierbaren Elektroden bei einer fest angelegten Spannung größer als im zuvor beschriebenen Fall zweier Elektroden mit zueinander antiparallelen Magnetisierungsrichtungen. Diese signifikante Abhängigkeit des elektrischen Widerstands von der relativen Orientierung der Magnetisierungen beider Elektroden zueinander würde jedoch verfälscht, wenn die Spin-Information der Leitungselektroden beim Durchlaufen der Nanoröhre verändert würde. Dies ist infolge der hohen Spinkohärenzlänge vermieden, weshalb Kohlenstoff-Nanoröhren besonders gut als Kopplungselement zwischen einer ersten magnetisierbaren Elektrode und einer zweiten magnetisierbaren Elektrode in einer magnetischen Speichereinheit geeignet ist. Dadurch ist das Signal zu Rauschverhältnis beim Auslesen der in einer magnetischen Speichereinheit gespeicherten Datenmenge erfindungsgemäß erhöht.

Vorzugsweise weist bei der magnetischen Speichereinheit die erste Elektrode ein erstes magnetisches Material und die zweite Elektrode ein zweites magnetisches Material auf, wobei beide Materialien eine unterschiedliche magnetische Härte aufweisen und auch als sogenannte Multilagenschichten ausgebildet sein können. Dabei sind die beiden Elektroden jeweils eine magnetisierbare Schicht, welche jeweils senkrecht zu der Längsachse der Nanoröhre angeordnet ist.

Wie oben beschrieben, wird unter einem hartmagnetischen Material ein Material mit einer hohen Fläche unter der Hysteresekurve verstanden, so dass ein solches Material nur schwer umzumagnetisieren ist. Dagegen weist ein weichmagnetisches Material eine Hysteresekurve mit einer geringen eingeschlossenen Fläche auf, so dass ein solches Material mittels eines kleinen externen Magnetfeldes ummagnetisierbar ist, wobei die Arbeit zum Ummagnetisieren in diesem Falle klein ist.

Eine der magnetisierbaren Elektroden der magnetischen Speichereinheit ist aus einem weichmagnetischen Material hergestellt. Die Magnetisierungsrichtung dieser Elektrode kann durch Anlegen eines kleinen externen magnetischen Feldes umgekehrt werden, so dass mittels Einstellen der Magnetisierungsrichtung der weichmagnetischen Elektrode die in der magnetischen Speichereinheit gespeicherte Information eingeschrieben oder gelöscht werden kann. Dagegen wird in die hartmagnetische Elektrode der magnetischen Speichereinheit einmalig mittels eines ausreichend starken externen Magnetfelds eine bestimmte Magnetisierungsrichtung eingeprägt und soll dann dauerhaft konstant bleiben. Alternativ kann Magnetisierung mittels Austauschwechselwirkung oder durch Formanisotropie erfolgen.

Als weichmagnetisches Material für eine der magnetisierbaren Elektroden wird häufig Eisen oder eine Eisen-Nickel-Legierung verwendet. Als Material für die hartmagnetische Elektrode wird häufig Kobalt verwendet. Es ist ein Vorteil der Erfindung, dass die als erstes magnetisches Material bzw. als zweites magnetisches Material mit unterschiedlichen magnetischen Härten geeigneten Materialien Eisen, Nickel, Kobalt Materialien sind, die besonders gut zum Aufwachsen von Kohlenstoff-Nanoröhren geeignet sind. Kohlenstoff-Nanoröhren wachsen bevorzugt auf für das Aufwachsen von Kohlenstoff-Nanoröhren katalytisch aktivem Material auf, beispielsweise auf Eisen, Nickel oder Kobalt. Daher sind die als Material für die erste magnetisierbare Elektrode bzw. die zweite magnetisierbare Elektrode geeigneten Materialien auch besonders gut zum Einbringen von Kohlenstoff-Nanoröhren zwischen aus diesen Materialien hergestellten Elektroden geeignet. Daher ist die magnetische Speichereinheit der Erfindung mit vertretbarem Aufwand herstellbar und die dazwischen einzubringenden Kohlenstoff-Nanoröhren sind mit einer hohen Qualität herstellbar.

Wie oben beschrieben, sind MRAM-Speichereinheiten gemäß dem Stand der Technik infolge des hohen Tunnelwiderstand von Tunnelschichten und der folglich hohen RC-Zeitkonstante häufig langsam. Die charakteristische Zeit, die zum Auslesen der in einer MRAM-Speichereinheit eingespeicherten Datenmenge erforderlich ist, ist durch die RC-Zeit der MRAM-Speichereinheit gegeben. Erfindungsgemäß ist der elektrische Widerstand der Speichereinheit mittels Verwenden einer Kohlenstoff-Nanoröhre als Kopplungselement zwischen den beiden magnetisierbaren Elektroden verringert, daher die RC-Zeit herabgesetzt und somit die Schnelligkeit der Speicherelemente erhöht. Infolge der sehr hohen Leitfähigkeit von Kohlenstoff-Nanoröhren liegt der Widerstand von Kohlenstoff-Nanoröhren in der Größenordnung der Klitzing-Konstante (Rₖ=25,8kΩ). Der Ersatzschaltkreis der magnetischen Speichereinheit weist einen Kondensator mit einer Kapazität C und einem ohmschen Widerstand mit einem Wert R auf, wobei das Produkt aus R und C als Maß für die Auslesezeit der in der magnetischen Speichereinheit eingespeicherten Datenmenge interpretierbar ist. Indem erfindungsgemäß der elektrische Widerstand des Kopplungselements zwischen der ersten magnetisierbaren Elektroden und der zweiten magnetisierbaren Elektrode, verglichen mit dem elektrischen Widerstand einer Tunnelschicht gemäß dem Stand der Technik, deutlich herabgesetzt ist, ist die RC-Zeit erfindungsgemäß erniedrigt und daher eine magnetische Speichereinheit bereitgestellt, die mit verkürzten Auslesezeiten betreibbar ist.

Ferner ist erfindungsgemäß ein magnetisches Speicherarray mit einer Vielzahl von magnetischen Speichereinheiten, welche magnetischen Speichereinheiten vorangehend beschrieben sind, bereitgestellt.

Im Weiteren wird das erfindungsgemäße Speicherarray, das erfindungsgemäße Speichereinheiten aufweist, näher beschrieben. Ausgestaltungen der Speichereinheit gelten auch für das Speichereinheiten aufweisende Speicherarray.

Vorzugsweise sind die Speichereinheiten an den Kreuzungspunkten eines zweidimensionalen Gitters angeordnet, welches mittels einer ersten und einer zweiten Gitterachse bestimmt ist. Bei dem magnetischen Speicherarray sind jeweils diejenigen ersten Elektroden mit einer ersten Leiterbahn gekoppelt, welche ersten Elektroden entlang einer Linie parallel zu der ersten Gitterachse angeordnet sind. Ferner sind jeweils diejenigen zweiten Elektroden mit einer zweiten Leiterbahn gekoppelt, welche zweiten Elektroden entlang einer Linie parallel zu der zweiten Gitterachse angeordnet sind. Mit anderen Worten ist eine Mehrzahl von zueinander parallel angeordneten ersten Leiterbahnen derart eingerichtet, dass die Leiterbahnen entlang einer ersten Gitterachse eines zweidimensionalen Gitters verlaufen. Vorzugsweise senkrecht zu der ersten Gitterachse verläuft eine zweite Gitterachse, entlang derer eine Mehrzahl von zueinander parallel angeordneten zweiten Leiterbahnen verläuft. In Draufsicht bilden die ersten Leiterbahnen und die zweiten Leiterbahnen ein zweidimensionales Gitter aus. Allerdings sind vorzugsweise die ersten Leiterbahnen in einer ersten Ebene vorgesehen und die zweiten Leiterbahnen in einer zweiten Ebene, die zu der ersten Ebene vorzugsweise parallel und in einem Abstand dazu angeordnet ist. In jedem Kreuzungsbereich einer der ersten Leiterbahnen mit einer der zweiten Leiterbahnen ist eine magnetische Speichereinheit, wie sie oben beschrieben ist, angeordnet. Dabei ist die erste magnetisierbare Elektrode mit einer der ersten Leiterbahnen gekoppelt und die zweite magnetisierbare Elektrode mit einer der zweiten Leiterbahnen gekoppelt, und die erste magnetisierbare Elektrode ist mit der zweiten magnetisierbare Elektrode mittels mindestens einer Nanoröhre gekoppelt. Die mindestens eine Nanoröhre verläuft vorzugsweise in einer Richtung senkrecht zu den ersten Leiterbahnen und senkrecht zu den zweiten Leiterbahnen.

Auf die beschriebene Weise ist ein magnetisches Speicherarray bereitgestellt, mittels dem eine große Datenmenge mit einer hohen Integrationsdichte bei kurzen Zugriffszeiten speicherbar ist.

Bei dem erfindungsgemäßen magnetischen Speicherarray sind vorzugsweise jeweils diejenigen ersten Elektroden als gemeinsame einstückige Elektrode ausgebildet, welche ersten Elektroden entlang einer Linie parallel zu der ersten Gitterachse angeordnet sind.

Gemäß diesem Szenario sind vorzugsweise die ersten magnetisierbaren Elektroden der magnetischen Speichereinheit aus dem hartmagnetischen Material hergestellt, wohingegen die zweiten magnetisierbaren Elektroden aus dem weichmagnetischen Material hergestellt sind. Die aus einem hartmagnetischen Material hergestellte erste magnetisierbare Elektrode einer jeden Speichereinheit wird vorzugsweise vor Beginn des Einspeicherns von Daten in die magnetischen Speichereinheiten des magnetischen Speicherarrays der Erfindung einmalig durch ein hohes magnetisches Feld ausgerichtet und soll dann möglichst in der resultierenden Magnetisierungsorientierung verbleiben. Insbesondere ist zu vermeiden, dass infolge einer magnetischen Wechselwirkung zwischen einer der ersten magnetisierbaren Elektroden und einer der zweiten magnetisierbaren Elektroden die der ersten magnetisierbaren Elektrode vorgegebene Magnetisierungsrichtung verändert wird.

Indem gemäß der beschriebenen Ausgestaltung jeweils diejenigen ersten Elektroden als gemeinsame einstückige Elektrode ausgebildet sind, welche ersten Elektroden entlang einer Linie parallel zu der ersten Gitterachse angeordnet sind, ist die Magnetisierung der als gemeinsame einstückige Elektrode ausgebildeten ersten Elektroden aus dem hartmagnetischen Material stabilisiert. Alternativ kann die Magnetisierung mittels Formanisotropie erfolgen. Anschaulich ist eine wesentlich höhere magnetische Feldkraft erforderlich, um eine entlang einer ersten Leiterbahn durchgehend verlaufende gemeinsame einstückige erste Elektrode mit einer durchgehenden Magnetisierungsrichtung umzumagnetisieren, da die Anzahl der unzumagnetisierenden atomaren Elementarmagneten proportional zu der Anzahl der Atome in der ersten Elektrode ist. Ist die Anzahl der magnetischen Atome wie im Falle einer einstückig ausgebildeten. Elektrode groß, so erfordert deren Ummagnetisieren ein hohes magnetisches Feld bzw. eine große aufzuwendende Arbeit. Eine gemeinsame einstückige erste Elektrode weist wesentlich mehr geordnete atomare Spins auf, als eine erste Elektrode, deren Dimension durch den Kreuzungsbereich einer der ersten Leiterbahnen mit einer der zweiten Leiterbahnen vorgegeben ist. Es ist anschaulich verständlich, dass zum Ummagnetisieren dieser erhöhten Anzahl von Spins in der gemeinsamen einstückigen ersten Elektrode höhere magnetische Felder erforderlich sind und mehr magnetische Energie aufgewendet werden muss als bei den wenigen Spins, die bei einer ersten Elektrode, deren Dimension auf den Kreuzungsbereich einer der ersten Leiterbahnen mit einer der zweiten Leiterbahnen begrenzt ist, auftreten. Infolge des einstückigen Ausbildens der entlang einer Leiterbahn angeordneten ersten Elektroden ist die hartmagnetische Schicht der magnetischen Speichereinheiten vor einem unerwünschten Umklappen der Magnetisierung infolge von Magnetfeldern, die etwa zum Einspeichern oder Auslesen der Magnetisierungsrichtung der zweiten Elektroden der Speichereinheiten angelegt sind, geschützt.

Das Einspeichern einer Magnetisierungsrichtung in eine der zweiten magnetisierbaren Elektroden einer magnetischen Speichereinheit des magnetischen Speicherarrays kann dadurch realisiert sein, dass an diejenige erste Leiterbahn und an diejenige zweite Leiterbahn, in deren Kreuzungsbereich eine zu programmierende magnetische Speichereinheit angeordnet ist, geeignete elektrische Ströme eingespeist werden. Diese beiden stromdurchflossenen Leiter erzeugen dann Magnetfelder, mittels derer die zweite magnetisierbare Elektrode in derjenige magnetischen Speichereinheit, die in dem Kreuzungsbereich der stromdurchflossenen ersten Leiterbahn und der stromdurchflossenen zweiten Leiterbahn angeordnet ist, ummagnetisiert wird. Gemäß der beschriebenen Ausgestaltung des magnetischen Speicherarrays, bei dem jeweils diejenigen ersten Elektroden als gemeinsame einstückige Elektrode ausgebildet sind, welche ersten Elektroden entlang einer Linie parallel zu der ersten Gitterachse angeordnet sind, ist die gemeinsame einstückige Elektrode selbst der Stromträger, der das magnetische Signal zum Ummagnetisieren einer zweiten magnetisierbaren Elektrode einer Speichereinheit bereitstellt. Dadurch sind die als gemeinsame einstückige Elektrode ausgebildeten ersten Elektroden aus dem hartmagnetischen Material, das vor Ummagnetisierung zu schützen ist, vorteilhafterweise zusätzlich vor einem unerwünschten Umklappen der Magnetisierungsrichtung geschützt.

Alternativ zu der soeben beschriebenen Ausgestaltung des magnetischen Speicherarrays können bei dem magnetischen Speicherarray jeweils diejenigen zweiten Elektroden als gemeinsame einstückige Elektrode ausgebildet sein, welche zweiten Elektroden entlang einer Linie parallel zu der zweiten Gitterachse angeordnet sind. In diesem Falle sind die zweiten Elektroden aus dem hartmagnetischen Material herzustellen und die ersten Elektroden aus dem weichmagnetischen Material herzustellen. Die obige Argumentation ist dann analog zu führen, wobei gemäß der nun beschriebenen Ausgestaltung die ersten Elektroden die Funktion der zweiten Elektroden gemäß der zuvor beschriebenen Ausgestaltung wahrnehmen und umgekehrt.

Ausführungsbeispiele der Erfindung sind in den Figuren dargestellt und werden im Weiteren erläutert.

Es zeigen:
- Figur 1: eine Ansicht einer magnetischen Speichereinheit gemäß dem Stand der Technik,
- Figur 2: eine Ansicht einer magnetischen Speichereinheit gemäß einem bevorzugten Ausführungsbeispiel der Erfindung,
- Figur 3: eine Ansicht eines magnetischen Speicherarrays gemäß einem ersten bevorzugten Ausführungsbeispiel der Erfindung,
- Figur 4: eine Ansicht eines magnetischen Speicherarrays gemäß einem zweiten bevorzugten Ausführungsbeispiel der Erfindung.

Bezugnehmend auf **Fig. 2** wird im Folgenden ein bevorzugtes Ausführungsbeispiel der magnetischen Speichereinheit der Erfindung beschrieben. Die magnetische Speichereinheit 200 weist eine erste magnetisierbare Elektrode 201, eine zweite magnetisierbare Elektrode 202 und eine Nanoröhre 203 auf, welche zwischen den Elektroden 201, 202 in Längsrichtung angeordnet ist und welche mit ihrem ersten Längsende 203a mit der ersten Elektrode 201 und mit ihrem zweiten Längsende 203b mit der zweiten Elektrode 202 gekoppelt ist. Die Nanoröhre 203 ist eine Kohlenstoff-Nanoröhre.

Die Nanoröhre 203 ist derart eingerichtet, dass sie einen quantenmechanischen Tunnelkontakt darstellt, wobei der Spinzustand von zwischen den beiden Elektroden 201, 202 fließenden Ladungsträgern beim Durchgang durch die Nanoröhre zumindest teilweise erhalten bleibt. Die erste Elektrode 201 weist ein erstes magnetisches Material auf und die zweite Elektrode 202 weist als zweites magnetisches Material auf, wobei beide Materialien eine unterschiedliche magnetische Härte aufweisen. Die erste magnetisierbare Elektrode 201 ist aus einem weichmagnetischen Material hergestellt, im Falle der magnetischen Speichereinheit 200 ist die erste magnetisierbare Elektrode 201 aus einer Eisen-Nickel-Legierung hergestellt. Die zweite magnetisierbare Elektrode 202 ist aus einem hartmagnetischen Material hergestellt, nämlich aus Kobalt-Material. Die beiden Elektroden 201, 202 sind jeweils eine magnetisierbare Schicht, welche jeweils senkrecht zu der Längsachse der Nanoröhre 203 angeordnet sind, wie in **Fig. 2** gezeigt.

In **Fig. 2** ist ferner gezeigt, dass die beiden Elektroden 201, 202 in einem Abstand "d" voneinander angeordnet sind. Der Abstand d entspricht der Länge der Nanoröhre 203 und kann etwa zwischen 1nm und 300nm betragen. Gemäß dem in **Fig. 2** dargestellten Ausführungsbeispiel der magnetischen Speichereinheit 200 ist die Länge der Nanoröhre 203 ungefähr 250nm. Dies entspricht in etwa der Spinkohärenzlänge von Nanoröhren, also derjenigen Länge einer Nanoröhre, über die hinweg ein spinpolarisiertes Leitungselektron ohne Spinumklappprozess hin transportiert werden kann, so dass die Spin-Information des Leitungselektrons beim Durchlaufen der Nanoröhre 203 erhalten bleibt.

In **Fig. 2** sind ferner mit Pfeilen die Magnetisierungsrichtungen der ersten magnetisierbaren Elektrode 201 bzw. der zweiten magnetisierbaren Elektrode 202 gezeigt. Die zweite magnetisierbare Elektrode 202, die gemäß dem gezeigten Ausführungsbeispiel aus dem hartmagnetischen Material hergestellt ist, weist eine Magnetisierungsrichtung 205 auf, wobei die Magnetisierungsrichtung 205 in **Fig. 2** mit einen von links nach rechts gerichteten Pfeil gekennzeichnet ist. Gemäß dem in **Fig. 2** gezeigten Betriebszustand der magnetischen Speichereinheit 200 ist die Magnetisierungsrichtung 204a der ersten magnetisierbaren Elektrode 201 als von rechts nach links gerichteter Pfeil mit durchgezogener Linie gekennzeichnet. Im Gegensatz zur zweiten magnetisierbaren Elektrode 202, die idealerweise dauerhaft in dem in **Fig. 2** gezeigten Magnetisierungszustand 205 verbleibt, ist mittels Anlegen eines geeigneten externen magnetischen Feldes die Magnetisierungsrichtung der ersten magnetisierbaren Elektrode 201 von der in **Fig. 2** gezeigten ersten Magnetisierungsrichtung 204a in eine zu der ersten Magnetisierungsrichtung 204a entgegengesetzte zweite Magnetisierungsrichtung 204b ummagnetisierbar. Die Tatsache, dass die erste magnetisierbare Elektrode 201 nicht nur in dem in **Fig. 2** gezeigten Betriebszustand mit der Magnetisierungsrichtung 204a, sondern auch in einem Betriebszustand mit einer dazu entgegengesetzten Magnetisierungsrichtung 204b auftreten kann, ist in **Fig. 2** dadurch gekennzeichnet, dass die von links nach rechts gerichtete zweite Magnetisierungsrichtung 204b mit einem gestrichelten Pfeil eingezeichnet ist.

Es ist zu betonen, dass die Magnetisierungsrichtungen 204a, 204b der ersten magnetisierbaren Elektrode 201 und die Magnetisierungsrichtung 205 der zweiten magnetisierbaren Elektrode 202, die gemäß dem in **Fig. 2** gezeigten Ausführungsbeispiel in horizontaler Richtung verlaufen auch in gemäß **Fig. 2** vertikaler oder in einer sonstigen Richtung verlaufen können (nicht gezeigt in den Figuren).

In dem bezugnehmend auf **Fig. 2** gezeigten Betriebszustand der magnetischen Speichereinheit 200 sind die Magnetisierungsrichtungen der ersten magnetisierbaren Elektrode 201 und der zweiten magnetisierbaren Elektrode 202 zueinander entgegengesetzt, d.h. um 180° gegeneinander verdreht. Gemäß dem oben beschriebenen Riesenmagnetowiderstands-Effekt erfolgt der Stromfluss von der ersten magnetisierbaren Elektrode 201 durch die Nanoröhre 203 hindurch zu der zweiten magnetisierbaren Elektrode 202 mit einen hohen elektrischen Widerstand. In einem in den Figuren nicht gezeigten Betriebszustand der magnetischen Speichereinheit 200, in dem die erste magnetisierbare Elektrode 201 die zweite Magnetisierungsrichtung 204b aufweist und die zweite magnetisierbare Elektrode 202 unverändert die Magnetisierungsrichtung 205 aufweist, ist dagegen der elektrische Widerstand für einen zwischen der ersten magnetisierbaren Elektrode 201 und der zweiten magnetisierbaren Elektrode 202 fließenden elektrischen Strom geringer als gemäß dem zuvor beschriebenen Szenario.

In der in **Fig. 2** gezeigten magnetischen Speichereinheit 200 ist daher eine Datenmenge von 1 Bit speicherbar, die mittels der relativen Orientierung der Magnetisierungsrichtungen 204a bzw. 204b und 205 der ersten magnetisierbaren Elektrode 201 und der zweiten magnetisierbaren Elektrode 202 kodiert ist. Weist in einer magnetischen Speichereinheit 200 die erste magnetisierbare Elektrode 201 die erste Magnetisierungsrichtung 204b auf und weist die zweite magnetisierbare Elektrode 202 die Magnetisierungsrichtung 205 auf, so sind die Magnetisierungsrichtungen der ersten und der zweiten Elektrode 201, 202 zueinander parallel, der elektrische Widerstand der magnetischen Speichereinheit 200 gering und der Stromfluss durch die magnetische Speichereinheit 200 bei einer festen externen elektrischen Spannung groß. Dies kann beispielsweise als logischer Wert "0" interpretiert werden. Weist dagegen die erste magnetisierbare Elektrode 201 die erste Magnetisierungsrichtung 204a auf, so sind die Magnetisierungsrichtungen der ersten und der zweiten magnetisierbaren Elektroden 201, 202 zueinander antiparallel, so dass der elektrische Widerstand der magnetischen Speichereinheit 200 hoch ist und der elektrische Stromfluss durch die magnetische Speichereinheit 200 bei einer festen externen Spannung gering ist. Dies kann beispielsweise als logischer Wert "1" interpretiert werden.

Wichtig für die Funktionalität der magnetischen Speichereinheit 200 ist, dass die Leitungselektronen, die in der ersten magnetisierbaren Elektrode 201 aufgrund deren ferromagnetischen Charakters spinpolarisiert werden, zumindest teilweise ohne Änderung des Spinzustands durch die Nanoröhre 203 bis hin in die zweite magnetisierbare Elektrode 202 transportiert werden. Mit anderen Worten muss die Spinvorzugsrichtung der Leitungselektronen, die in die Nanoröhre 203 injiziert werden, beim Durchgang durch die Nanoröhre überwiegend aufrechterhalten bleiben. Dadurch ist ermöglicht, dass der Riesenmagnetowiderstands-Effekt an der magnetischen Speichereinheit 200 auftreten kann und die unterschiedlichen elektrischen Widerstände in den beiden beschriebenen Betriebszuständen der magnetischen Speichereinheit 200 elektrisch erfassbar sind. Dies ist erfindungsgemäß realisiert, indem die Nanoröhre eine Länge "d" (siehe **Fig. 2**) aufweist, wobei d gemäß dem in **Fig. 2** gezeigten Ausführungsbeispiel der magnetischen Speichereinheit 200 etwa 250nm ist. Dadurch ist die Länge der Nanoröhre 203 in etwa gleich der Spinkohärenzlänge einer Nanoröhre. Die Nanoröhre 203 weist ferner einen ausreichend geringen elektrischen Widerstand auf, so dass die Zeitkonstante, mit der die magnetische Speichereinheit 200 betreibbar ist, ausreichend gering ist.

Auf diese Weise ist erfindungsgemäß eine magnetische Speichereinheit 200 bereitgestellt, bei der auf die darin kodierte Speicher-Information ausreichend schnell zugreifbar ist. Indem infolge der ausreichend lang gewählten Nanoröhre 203 der Abstand zwischen der ersten magnetisierbaren Elektrode 201 und der zweiten magnetisierbaren Elektrode 202 ausreichend hoch ist, ist eine unerwünschte Wechselwirkung zwischen den durch die erste magnetisierbare Elektrode 201 bzw. die zweite magnetisierbare Elektrode 202 erzeugten Magnetfeldern vermieden. Das Einspeichern der ersten Magnetisierungsrichtung 204a oder alternativ der zweiten Magnetisierungsrichtung 204b in die erste magnetisierbare Elektrode 201, das in der Regel mittels Anlegen eines externen Magnetfelds realisiert wird, wirkt sich aufgrund des ausreichend großen Abstandes d nur auf die erste magnetisierbare Elektrode 201 aus, wohingegen aufgrund des hohen Abstandes d die zweite magnetisierbare Elektrode 202 von dem externen Magnetfeld zum Einspeichern der Magnetisierungsrichtung in die erste magnetisierbare Elektrode 201 ausreichend gut abgeschirmt ist. Dabei ist der physikalische Effekt ausgenutzt, dass magnetische Felder mit zunehmendem Abstand von einem magnetischen Material abfallen.

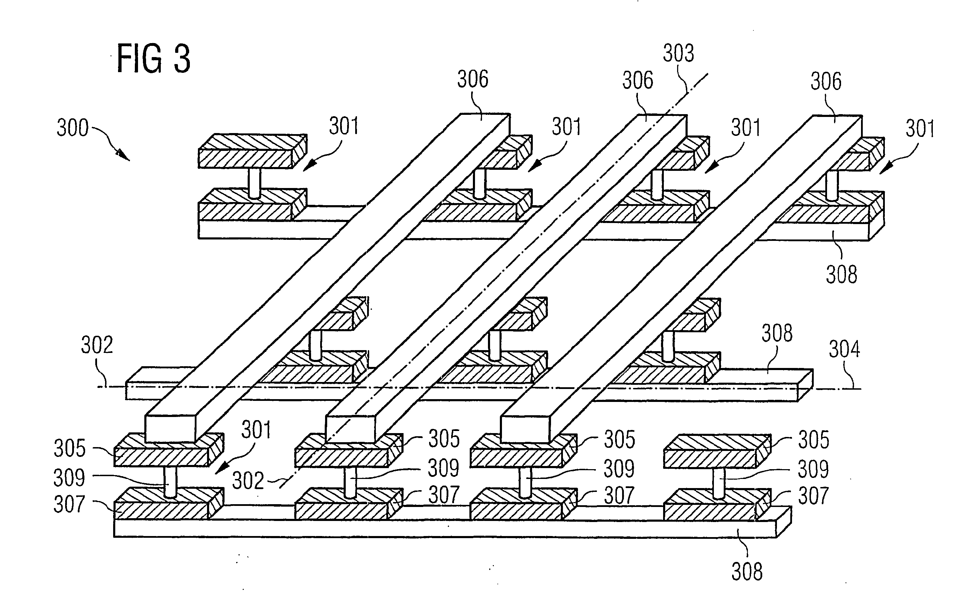

In **Fig. 3** ist ein erstes bevorzugtes Ausführungsbeispiel des erfindungsgemäßen magnetischen Speicherarrays 300 mit einer Vielzahl von magnetischen Speichereinheiten 301 gezeigt. Jede der magnetischen Speichereinheiten ist so aufgebaut wie die oben bezugnehmend auf **Fig. 2** beschriebene magnetische Speichereinheit 200.

Bei dem magnetischen Speicherarray 300 sind die Speichereinheiten 301 an den Kreuzungspunkten eines zweidimensionalen Gitters 302 angeordnet, welches mittels einer ersten Gitterachse 303 und einer zweiten Gitterachse 304 bestimmt ist. Bei dem magnetischen Speicherarray 300 sind jeweils diejenigen ersten magnetisierbaren Elektroden 305 einer Speichereinheit 301 mit einer ersten Leiterbahn 306 gekoppelt, welche ersten magnetisierbaren Elektroden 305 entlang einer Linie parallel zu der ersten Gitterachse 303 angeordnet sind. Ferner sind jeweils diejenigen zweiten magnetisierbaren Elektroden 307 der magnetischen Speichereinheiten 301 mit einer zweiten Leiterbahn 308 gekoppelt, welche zweiten magnetisierbaren Elektroden 307 entlang einer Linie parallel zu der zweiten Gitterachse 304 angeordnet sind.

Im Weiteren wird beschrieben, wie das magnetische Speicherarray der Erfindung gemäß dem in **Fig. 3** gezeigten Ausführungsbeispiel prinzipiell betreibbar ist.

Zunächst wird beschrieben, wie in eine bestimmte magnetische Speichereinheit 301 eine Datenmenge von 1 Bit einprogrammierbar ist. Dazu wird an diejenige erste Leiterbahn 306 und an diejenige zweite Leiterbahn 308, in deren Kreuzungsbereich die anzusteuernde magnetische Speichereinheit 301 angeordnet ist, jeweils ein elektrischer Strom angelegt. Die elektrische Stromstärke ist dabei so zu wählen, dass die im Wesentlichen ringförmigen Magnetfelder, die von der stromdurchflossenen ersten Leiterbahn 306 bzw, von der stromdurchflossenen zweiten Leiterbahn 308 erzeugt werden, sich nur in dem Kreuzungsbereich der auszuwählenden magnetischen Speichereinheit 301 derartig überlagern, dass die resultierende magnetische Feldstärke an dessen Ort ausreicht, um die Magnetisierungsrichtung der in diesem Kreuzungsbereich angeordneten ersten magnetisierbaren Elektrode 305 aus dem weichmagnetischen Material umzuklappen. Die magnetischen Streufelder an allen anderen magnetischen Speichereinheiten 301 sind nicht ausreichend groß, um die Magnetisierungsrichtung der in diesen Kreuzungsbereichen angeordneten ersten magnetisierbaren Elektroden 305 zu verändern. Dadurch wird nur in die in dem Kreuzungsbereich zwischen der stromdurchflossenen ersten Leiterbahn 306 und der stromdurchflossenen Leiterbahn 308 angeordneten ersten magnetisierbaren Elektrode 305 die Magnetisierungsrichtung umgedreht und dadurch ein logischer Wert "1" bzw. "0" eingespeichert. Ferner ist die sich in dem Kreuzungsbereich der stromdurchflossenen ersten Leiterbahn 306 und der stromdurchflossenen zweiten Leiterbahn 308 überlagernde Magnetfeldstärke zwar ausreichend groß, um die aus dem weichmagnetischen Material hergestellte in dem Kreuzungsbereich angeordnete erste magnetisierbare Elektrode 305 in ihrer Magnetisierungsrichtung zu beeinflussen, wohingegen die sich überlagernde Magnetfeldstärke nicht ausreichend groß ist, um die aus dem hartmagnetischen Material hergestellte zweite magnetisierbare Elektrode 307 umzumagnetisieren.

Im Folgenden wird beschrieben, wie die in jeder magnetischen Speichereinheit 301 gespeicherte Datenmenge von 1 Bit auslesbar ist. Hierzu wird beispielsweise mit einem in **Fig. 3** nicht gezeigten Mittel zum Erfassen einer elektrischen Spannung der Spannungsabfall an einer magnetischen Speichereinheit 301 erfasst. Dieser Spannungsabfall ist bei einer vorgegebenen elektrischen Stromstärke groß, wenn der elektrische Widerstand der magnetischen Speichereinheit 301 groß ist, d.h. wenn die Magnetisierungsrichtungen der ersten magnetisierbaren Elektrode 30, und der zweiten magnetisierbaren Elektrode 307 der magnetischen Speichereinheit 301 zueinander antiparallel orientiert sind (Riesenmagnetowiderstands-Effekt). Diesem Szenario wird der logische Wert "1" zugeordnet. Der Abfall der elektrischen Spannung an der magnetischen Speichereinheit 301 ist dagegen gering, wenn der elektrische Widerstand der magnetischen Speichereinheit 301 gering ist, d.h. wenn die Magnetisierungsrichtungen der ersten magnetisierbaren Elektrode 305 und der zweiten magnetisierbaren Elektrode 307 zueinander parallel sind. Diesem Szenario wird der logische Wert "0" zugeordnet.

Alternativ zum Erfassen des Spannungsabfalls an der magnetischen Speichereinheit 301 kann beispielsweise der elektrische Stromfluss durch die magnetische Speichereinheit 301 bei einer konstanten extern angelegten elektrischen Spannung erfasst werden.

Bei dem beschriebenen Erfassen des elektrischen Widerstands der Speichereinheit 301 ist die Funktionalität der in jeder Speichereinheit 301 vorhandenen mindestens einen Nanoröhre 309 maßgeblich. Die Abhängigkeit des elektrischen Widerstands von der relativen Orientierung der Magnetisierungen der ersten magnetisierbaren Elektrode 305 und der zweiten magnetisierbaren Elektrode 307 zueinander beruht darauf, dass die Spinvorzugsrichtung von Leitungselektroden, die von der magnetisierbaren Elektrode 305 den Leitungselektroden aufgeprägt wird, beim Durchlaufen der Nanoröhre 309 aufrechterhalten bleibt, d.h. dass zumindest ein Teil der Leitungselektroden die Nanoröhre 309 ohne einen Spinumkehrprozess durchläuft. Dies ist durch Kopplung der ersten magnetisierbaren Elektrode 305 und der zweiten magnetisierbaren Elektrode 307 mittels einer Nanoröhre 309 realisiert. Ferner sind die Nanoröhren 309 ausreichend niederohmig, um die Auslesezeit für eine magnetische Speichereinheit 301 gering zu halten.

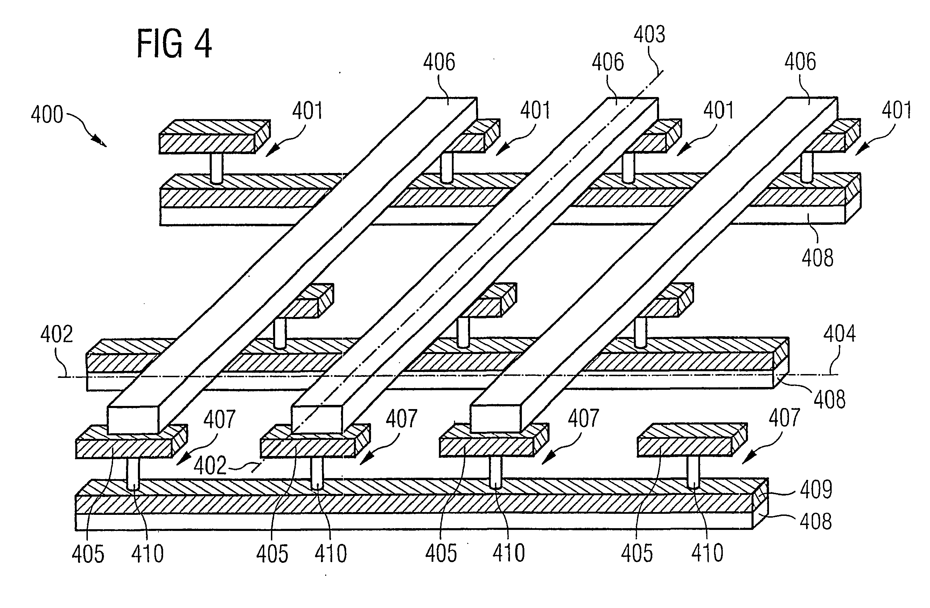

Bezugnehmend auf **Fig. 4** wird im Folgenden ein zweites bevorzugtes Ausführungsbeispiel des erfindungsgemäßen magnetischen Speicherarrays 400 mit einer Vielzahl von magnetischen Speichereinheiten 401 beschrieben.

Bei dem magnetischen Speicherarray 400 sind die magnetischen Speichereinheiten 401 an den Kreuzungspunkten eines zweidimensionalen Gitters 402 angeordnet, welches mittels einer ersten Gitterachse 403 und einer zweiten Gitterachse 404 bestimmt ist. Bei dem magnetischen Speicherarray 400 sind jeweils diejenigen magnetisierbaren Elektroden 405 jeweils mit einer ersten Leiterbahn 406 gekoppelt, welche ersten Elektroden 405 entlang einer Linie parallel zu der ersten Gitterachse 403 angeordnet sind. Ferner sind jeweils diejenigen zweiten magnetisierbaren Elektroden 407 jeweils mit einer zweiten Leiterbahn 408 gekoppelt, welche zweiten magnetisierbaren Elektroden 407 entlang einer Linie parallel zu der zweiten Gitterachse 404 angeordnet sind. Gemäß dem in **Fig. 4** gezeigten magnetischen Speicherarray 400 sind jeweils diejenigen zweiten magnetisierbaren Elektroden 407 als gemeinsame einstückige Elektrode 409 ausgebildet, welche zweiten magnetisierbaren Elektrode 407 entlang einer Linie parallel zu der zweiten Gitterachse 404 angeordnet sind. Bei den magnetischen Speichereinheiten 401 in den Kreuzungsbereichen der gemeinsamen einstückigen Elektroden 409 mit den ersten Leiterbahnen 406 ist jede gemeinsame einstückige Elektrode 409 mittels Kohlenstoff-Nanoröhren 410 mit den im Wesentlichen oberhalb der gemeinsamen einstückigen Elektrode 409 angeordneten ersten magnetisierbaren Elektroden 405 gekoppelt.

Die Funktionalität des magnetischen Speicherarrays 400 bezüglich Lesen bzw. Einspeichern von Datenmengen in die magnetischen Speichereinheiten 401 entspricht im Wesentlichen der Funktionalität des magnetischen Speicherarrays 300, das in **Fig. 3** gezeigt ist. Das Ausbilden der zweiten magnetisierbaren Elektroden 407 zu gemeinsamen einstückigen Elektroden 409 in der in **Fig. 4** gezeigten Weise stabilisiert jedoch zusätzlich die Magnetisierungsrichtung der zweiten magnetisierbaren Elektroden 407, die wie oben ausgeführt aus dem hartmagnetischen Material hergestellt sind, wohingegen die ersten magnetisierbaren Elektroden 405 aus dem weichmagnetisierbaren Material hergestellt sind. Entsprechend der Funktionalität des magnetischen Speicherarrays 400 soll daher die Magnetisierungsrichtung der gemeinsamen einstückigen Elektroden 409 dauerhaft konstant sein, auch wenn Daten in die magnetischen Speichereinheiten 401 eingespeichert oder ausgelesen werden und zu diesem Zweck Magnetfelder an das magnetische Speicherarray 400 angelegt sind. Indem die entlang einer zweiten Leiterbahn 408 angeordneten zweiten magnetisierbaren Elektroden 407 zu einer gemeinsamen einstückigen Elektrode 409 zusammengefasst sind, liegt ein durchgehender Bereich 409 einer im Wesentlichen einheitlichen Magnetisierungsrichtung vor. Es ist eine hohe physikalische Arbeit bzw. ein hohes externes Magnetfeld erforderlich, um diese großräumige einstückige gemeinsame Elektrode 409 umzumagnetisieren. Alternativ kann die Magnetisierung mittels Formanisotropie erfolgen. Daher ist infolge des Ausbildens der zweiten magnetisierbaren Elektroden 407 entlang einer zweiten Leiterbahn 408 zu einer gemeinsamen einstückigen Elektrode 409 die Magnetisierung der gemeinsamen einstückigen Elektrode 409 stabilisiert und vor negativen Einflüssen beispielsweise infolge magnetischer Streufelder besser geschützt. Gemäß dem in **Fig. 4** gezeigten Ausführungsbeispiel des magnetischen Speicherarrays 400 ist die gemeinsame einstückige Elektrode 409 beim Einspeichern von Daten in einzelne magnetische Speichereinheiten 401 selbst der Stromträger, der den magnetischen Puls zum Ummagnetisieren einer ersten magnetisierbaren Elektrode 405 erzeugt. Daher ist die gemeinsame einstückige Elektrode 409 beim Einspeichern von Daten in magnetische Speichereinheiten 401 selbst vor einem unerwünschten Ummagnetisieren geschützt. Das Programmieren von Daten in das magnetische Speicherarray 400 bzw. das Auslesen von Daten aus dem magnetischen Speicherarray 400 erfolgt wie oben bezugnehmend auf **Fig. 3** beschrieben.

In diesem Dokument sind folgende Veröffentlichungen zitiert:
[1] Harris, PJF (1999) "Carbon Nanotubes and Related Structures - New Materials for the Twenty-first Century.", Cambridge University Press, Cambridge
[2] Dekker, C et al. (1999) "Carbon Nanotubes as Molecular Quantum Wires", Physics Today 5/99:22-28
[3] Tsukagoshi, K et al. (1999) "Coherent transport of electron spin in a ferromagnetically contacted carbon nanotube" Nature 401:572-574
[4] Reiss, G et al. (1998) "Riesenmagnetowiderstand - Transfer in die Anwendung" Physikalische Blätter 4/98:339-341
[5] Prinz, GA (1999) "Magnetoelectronics applications" Journal of Magnetism and Magnetic Material 200:57-68
[6] EP 1,052,520 A1
[7] US 5,640,343
[8] Parkin, SSP, Roche, KP, Samant, MG, Rice, PM, Beyers, RB, Scheuerlein, RE, O'Sullivan, EJ, Brown, SL, Bucchignano, J, Abraham, DW, Lu, Y, Rooks, M, Trouilloud, PL, Wanner, RA, Gallagher, WJ (1999) "Exchange-biased magnetic tunnel junctions and application to nonvolatile magnetic random access memory" Journal of Applied Physics Vol.85(8):5828-5833

### Bezugszeichenliste

- 100: MRAM-Speichereinheit
- 101: weichmagnetische Elektrode
- 101a: momentane Magnetisierungsrichtung
- 101b: alternative Magnetisierungsrichtung
- 102: hartmagnetische Elektrode
- 102a: Magnetisierungsrichtung
- 103: Tunnelschicht
- 104: elektrisch leitfähige Zuleitungen

- 200: magnetische Speichereinheit
- 201: erste magnetisierbare Elektrode
- 202: zweite magnetisierbare Elektrode
- 203: Nanoröhre
- 203a: erstes Längsende
- 203b: zweites Längsende
- 204a: erste Magnetisierungsrichtung der ersten Elektrode
- 204b: zweite Magnetisierungsrichtung der ersten Elektrode
- 205: Magnetisierungsrichtung der zweiten Elektrode

- 300: magnetisches Speicherarray
- 301: magnetische Speichereinheit
- 302: zweidimensionales Gitter
- 303: erste Gitterachse
- 304: zweite Gitterachse
- 305: erste magnetisierbare Elektrode
- 306: erste Leiterbahn
- 307: zweite magnetisierbare Elektrode
- 308: zweite Leiterbahn
- 309: Nanoröhre

- 400: magnetisches Speicherarray
- 401: magnetische Speichereinheit
- 402: zweidimensionales Gitter
- 403: erste Gitterachse
- 404: zweite Gitterachse
- 405: erste magnetisierbare Elektrode
- 406: erste Leiterbahn
- 407: zweite magnetisierbare Elektrode
- 408: zweite Leiterbahn
- 409: gemeinsame einstückige Elektrode
- 410: Nanoröhre

## Patentansprüche

1. Magnetische Speichereinheit
• mit einer ersten magnetisierbaren Elektrode, und
• mit einer zweiten magnetisierbaren Elektrode;
• wobei die magnetische Speichereinheit derart eingerichtet ist, dass in diese eine Speicherinformation mittels Einstellens einer Magnetisierungsrichtung einer der magnetisierbaren Elektroden mittels Anlegens eines externen Magnetfeldes nichtflüchtig einspeicherbar ist
**dadurch gekennzeichnet, daß** die erste und die zweite magnetisierbare Elektrode mit zumindest eine Nanoröhre, welche zwischen den Elektroden in Längsrichtung angeordnet ist und welche mit ihrem ersten Längsende mit der ersten Elektrode und mit ihrem zweiten Längsende mit der zweiten Elektrode gekoppelt ist, verbunden sind.

2. Magnetische Speichereinheit gemäß-Anspruch 1,
bei der die Nanoröhre eine Kohlenstoff-Nanoröhre ist.

3. Magnetische Speichereinheit gemäß Anspruch 1 oder 2,
bei der die Nanoröhre derart eingerichtet ist, dass sie einen quantenmechanischen Tunnelkontakt darstellt, wobei der Spinzustand von zwischen den beiden Elektroden fließenden Ladungsträgern zumindest teilweise erhalten bleibt.

4. Magnetische Speichereinheit gemäß einem der Ansprüche 1 bis 3,
bei der die erste Elektrode ein erstes magnetisches Material aufweist und bei der die zweite Elektrode ein zweites magnetisches Material aufweist, wobei beide Materialien eine unterschiedliche magnetische Härte aufweisen.

5. Magnetische Speichereinheit gemäß einem der Ansprüche 1 bis 4,
bei der die beiden Elektroden jeweils eine magnetisierbare Schicht sind, welche jeweils senkrecht zu der Längsachse der Nanoröhre angeordnet sind.

6. Magnetische Speichereinheit gemäß einem der Ansprüche 1 bis 5,
bei der die beiden Elektroden in einem Abstand von 1nm bis 300nm zueinander angeordnet sind.

7. Magnetisches Speicherarray mit einer Vielzahl von magnetischen Speichereinheiten gemäß einem der Ansprüche 1 bis 6.

8. Magnetisches Speicherarray gemäß Anspruch 7,
bei dem die Speichereinheiten an den Kreuzungspunkten eines zweidimensionalen Gitters angeordnet sind, welches mittels einer ersten und einer zweiten Gitterachse bestimmt ist.

9. Magnetisches Speicherarray gemäß Anspruch 8,
bei dem jeweils diejenigen ersten Elektroden mit einer ersten Leiterbahn gekoppelt sind, welche ersten Elektroden entlang einer Linie parallel zu der ersten Gitterachse angeordnet sind.

10. Magnetisches Speicherarray gemäß einem der Ansprüche 8 oder 9,
bei dem jeweils diejenigen zweiten Elektroden mit einer zweiten Leiterbahn gekoppelt sind, welche zweiten Elektroden entlang einer Linie parallel zu der zweiten Gitterachse angeordnet sind.

11. Magnetisches Speicherarray gemäß einem der Ansprüche 8 bis 10,
bei dem jeweils diejenigen ersten Elektroden als gemeinsame einstückige Elektrode ausgebildet sind, welche ersten Elektroden entlang einer Linie parallel zu der ersten Gitterachse angeordnet sind.

12. Magnetisches Speicherarray gemäß einem der Ansprüche 8 bis 10,
bei dem jeweils diejenigen zweiten Elektroden als gemeinsame einstückige Elektrode ausgebildet sind, welche zweiten Elektroden entlang einer Linie parallel zu der zweiten Gitterachse angeordnet sind.

## Claims

1. A magnetic memory unit
• having a first magnetizable electrode, and
• having a second magnetizable electrode;
• the magnetic memory unit being set up in such a way that a storage information item can be stored in it in nonvolatile fashion by means of the setting of a magnetization direction of one of the magnetizable electrodes by means of the application of an external magnetic field,
• **characterized in that** the first and the second magnetizable electrode are connected with at least one nanotube, which is arranged between the electrodes in the longitudinal direction and which is coupled to the first electrode by its first longitudinal end and to the second electrode by its second longitudinal end.

2. The magnetic memory unit as claimed in claim 1,
in which the nanotube is a carbon nanotube.

3. The magnetic memory unit as claimed in claim 1 or 2,
in which the nanotube is set up in such a way that it constitutes a quantum mechanical tunnel contact, the spin state of charge carriers that flow between the two electrodes being at least partly preserved.

4. The magnetic memory unit as claimed in one of claims 1 to 3,
in which the first electrode has a first magnetic material, and in which the second electrode has a second magnetic material, the two materials having a different magnetic hardness.

5. The magnetic memory unit as claimed in one of claims 1 to 4,
in which the two electrodes are in each case a magnetizable layer, which are in each case arranged perpendicular to the longitudinal axis of the nanotube.

6. The magnetic memory unit as claimed in one of claims 1 to 5,
in which the two electrodes are arranged at a distance of 1 nm to 300 nm from one another.

7. A magnetic memory array having a multiplicity of magnetic memory units as claimed in one of claims 1 to 6.

8. The magnetic memory array as claimed in claim 7,
in which the memory units are arranged at the crossover points of a two-dimensional grid determined by means of a first and a second grid axis.

9. The magnetic memory array as claimed in claim 8,
in which in each case those first electrodes are coupled to a first interconnect, which first electrodes are arranged along a line parallel to the first grid axis.

10. The magnetic memory array as claimed in either of claims 8 and 9,
in which in each case those second electrodes are coupled to a second interconnect, which second electrodes are arranged along a line parallel to the second grid axis.

11. The magnetic memory array as claimed in one of claims 8 to 10,
in which in each case those first electrodes are formed as a common integral electrode, which first electrodes are arranged along a line parallel to the first grid axis.

12. The magnetic memory array as claimed in one of claims 8 to 10,
in which in each case those second electrodes are formed as a common integral electrode, which second electrodes are arranged along a line parallel to the second grid axis.

## Revendications

1. Unité de mémoire magnétique
• ayant une première électrode magnétisable, et
• ayant une deuxième électrode magnétisable ;
• l'unité de mémoire magnétique étant conçue de telle sorte que l'on peut y mémoriser une information de mémoire sous une forme non volatile au moyen d'un réglage d'un sens de magnétisation de l'une des électrodes magnétisables en appliquant un champ magnétique externe,
**caractérisée par le fait que** la première et la deuxième électrode magnétisable sont reliées à au moins un nanotube qui est placé dans le sens de la longueur entre les électrodes et qui est couplé par sa première extrémité longitudinale à la première électrode et par sa deuxième extrémité longitudinale à la deuxième électrode.

2. Unité de mémoire magnétique selon la revendication 1,
dans laquelle le nanotube est un nanotube en carbone.

3. Unité de mémoire magnétique selon la revendication 1 ou 2,
dans laquelle le nanotube est conçu de telle sorte qu'il représente un contact tunnel en mécanique quantique, l'état de spin de porteurs de charge passant entre les deux électrodes étant au moins partiellement conservé.

4. Unité de mémoire magnétique selon l'une des revendications 1 à 3,
dans laquelle la première électrode a un premier matériau magnétique et dans laquelle la deuxième électrode a un deuxième matériau magnétique, les deux matériaux ayant une dureté magnétique différente.

5. Unité de mémoire magnétique selon l'une des revendications 1 à 4,
dans laquelle les deux électrodes sont chacune une couche magnétisable qui est disposée perpendiculairement à l'axe longitudinal du nanotube.

6. Unité de mémoire magnétique selon l'une des revendications 1 à 5,
dans laquelle les deux électrodes sont disposées à une distance de 1 nm à 300 nm l'une de l'autre.

7. Matrice de mémoire magnétique comprenant de nombreuses unités de mémoire magnétique selon l'une des revendications 1 à 6.

8. Matrice de mémoire magnétique selon la revendication 7,
dans laquelle les unités de mémoire sont disposées aux points d'intersection d'une grille bidimensionnelle qui est déterminée au moyen d'un premier et d'un deuxième axe de grille.

9. Matrice de mémoire magnétique selon la revendication 8,
dans laquelle les premières électrodes qui sont disposées le long d'une ligne parallèle au premier axe de grille sont couplées à une première piste conductrice.

10. Matrice de mémoire magnétique selon l'une des revendications 8 ou 9,
dans laquelle les deuxièmes électrodes qui sont disposées le long d'une ligne parallèle au deuxième axe de grille sont couplées à une deuxième piste conductrice.

11. Matrice de mémoire magnétique selon l'une des revendications 8 à 10,
dans laquelle les premières électrodes qui sont disposées le long d'une ligne parallèle au premier axe de grille sont conçues comme une électrode commune d'un seul tenant.

12. Matrice de mémoire magnétique selon l'une des revendications 8 à 10,
dans laquelle les deuxièmes électrodes qui sont disposées le long d'une ligne parallèle au deuxième axe de grille sont conçues comme une électrode commune d'un seul tenant.
